# EUROPÄISCHE PATENTSCHRIFT

(11) **EP 1 323 039 B1**
(45) Veröffentlichungstag und Bekanntmachung des Hinweises auf die Patenterteilung: **15.03.2006**
(21) Anmeldenummer: 01987916.2
(22) Anmeldetag: 02.10.2001
(51) Int. Cl.: G06F 11/00

(54) **VERFAHREN ZUM BETRIEB EINES VON EINEM PROZESSOR GESTEUERTEN SYSTEMS**
METHOD FOR OPERATING A PROCESSOR-CONTROLLED SYSTEM
PROCEDE POUR FAIRE FONCTIONNER UN SYSTEME COMMANDE PAR UN PROCESSEUR

(30) Priorität: 06.10.2000 DE 10049441
(43) Veröffentlichungstag der Anmeldung: 02.07.2003
(73) Patentinhaber: Conti Temic microelectronic GmbH, 90411 Nürnberg (DE)
(72) Erfinder: BECHER, Alwin, 90513 Zirndorf (DE); BERTELSHOFER, Peter, 90513 Zirndorf (DE); POHLMANN, Roger, 90765 Fürth-Stadeln (DE)
(86) Internationale Anmeldenummer: PCT/EP2001/011365
(87) Internationale Veröffentlichungsnummer: WO 2002/033549

(56) Entgegenhaltungen:
- DE-A- 3 345 863
- US-A- 4 488 303
- US-A- 6 076 172
- NAMJOO M: "TECHNIQUES FOR CONCURRENT TESTING OF VLSI PROCESSOR OPERATION" QUALITY PRODUCTIVITY PROFIT. PHILADELPHIA, 15 - 18 NOVEMBER 1982, INTERNATIONAL TEST CONFERENCE, SILVER SPRING, IEEE COMP. SOC. PRESS, US, Bd. SYMP. 1982, 1. November 1982 (1982-11-01), Seiten 461-468, XP000746184

## Beschreibung

Die Erfindung betrifft ein Verfahren zum Betrieb eines von einem Prozessor gesteuerten Systems.
Prozessorgesteuerte Systeme, bsp. durch Mikroprozessoren oder Mikrocontroller gesteuerte Systeme, werden insbesondere zur Realisierung bestimmter Anwendungen eingesetzt, wie bsp. zur Realisierung vorgegebener Funktionen oder Abläufe. Durch einen Fehler im System, bsp. durch eine Fehlfunktion im Prozessor oder einen Bitfehler in einer Speichereinheit des Systems, kann ein Anwendungsfehler auftreten, bsp. ein falscher Ablauf oder eine nicht beabsichtigte Funktion realisiert und ausgeführt werden. Dieses Fehlverhalten ist unerwünscht und störend und muß insbesondere bei prozessorgesteuerten Systemen zur Realisierung sicherheitskritischer Anwendungen (bei Kraftfahrzeugen bsp. den Tempomat, den Airbag oder die Lenkwinkelerkennung betreffende Anwendungen oder den Motor des Kraftfahrzeugs beeinflussende Steuergeräte) ausgeschlossen werden.
Um Fehlverhalten des Systems zu erkennen und/oder auszuschließen, insbesondere bei sicherheitskritischen Anwendungen, kann der Prozessor durch eine externe Überwachungseinheit überwacht werden, insbesondere durch einen externen Überwachungsrechner oder einen externen anwenderspezifischen Schaltkreis (ASIC); das System wird zurückgesetzt, außer Funktion gesetzt oder in einen sicheren Zustand geschaitet, wenn von der externen Überwachungseinheit eine Fehlfunktion des Prozessors erkannt wird. Nachteilig sind hierbei die Schwierigkeiten bei der Synchronisation von Prozessor und externer Überwachungseinheit, die bei der Kommunikation zwischen Prozessor und externer Überwachungseinheit möglichen Probleme, insbesondere mögliche EMV-Störungen auf den Verbindungsleitungen zwischen Prozessor und externer Überwachungseinheit, die zusätzlichen Kosten für die externe Überwachungseinheit sowie der Aufwand für Hardware, Entwicklung und Programmierung der externen Überwachungseinheit.

Ein derartiges Verfahren ist aus der DE 33 45 863 A1 bekannt. Ein Prozessor gibt ein Signal, das zwei unterschiedliche, periodisch wechselnde Datenwerte aufweist, an einen Watchdog-Timer ab, der die Ausführung des durch den Prozessor gesteuerten Programms überwacht. Der Watchdog-Timer weist ein Register, eine Vergleichsschaltung und einen Taktzähler auf. Das Register des Watchdog-Timers speichert die zwei Datenwerte. In der Vergleichsschaltung ist ein Bezügsdatenwert gespeichert, der einem der zwei Datenwerte entspricht: Bei Übereinstimmung von Bezugsdatenwert und dem im Register gespeicherten Datenwert gibt der Vergleicher ein Ausgangssignal ab. Ein Zähler zählt Taktpulse und gibt ein Rücksetzsignal an den Prozessor, wenn ein vorgegebener Zählwert erreicht ist. Der Zähler wird vom Ausgangssignal des Vergleichers zurückgesetzt. Wenn das Programm außer Kontrolle gerät, gibt der Vergleicher nicht mehr periodisch sein Ausgangssignal ab. Der Zähler wird nicht zurückgesetzt, erreicht den vorgegebenen Zählwert und setzt den Prozessor zurück.

Der Erfindung liegt die Aufgabe zugrunde, ein Verfahren zum Betrieb eines von einem Prozessor gesteuerten Systems anzugeben, bei dem der korrekte Betrieb des Systems, insbesondere für sicherheitskritische Anwendungen, auf einfache und kostengünstige Weise zuverlässig überwacht werden kann.
Diese Aufgabe wird erfindungsgemäß durch die Merkmale des Patentanspruchs 1 gelöst.
Vorteilhafte Ausgestaltungen des Verfahrens sind Bestandteil der weiteren Patentansprüche.

Der zur Steuerung des Systems vorgesehene Prozessor, bsp. ein eine bestimmte Funktion oder einen bestimmten Ablauf realisierender Prozessor, bsp. ein in einem Steuergerät implementierter Mikrocontroller, wird durch eine mit dem Prozessor in einem integrierten Schaltkreis integrierte, vom Prozessor unabhängig betriebene Überwachungseinheit hinsichtlich seiner Funktionsweise überwacht; die bsp. als vom Prozessor unabhängige Recheneinheit ausgebildete integrierte Überwachungseinheit ist mit dem Prozessor vorzugsweise über die Leitungen eines intemen Bussystems des integrierten Schaltkreises verknüpft. Die integrierte Überwachungseinheit wird bei der Initialisierung des Systems vom Prozessor nach Überprüfung ihrer Funktionsfähigkeit , gestartet und wird ab diesem Zeitpunkt unabhängig vom Prozessor betrieben; d.h. der Prozessor kann auf die integrierte Überwachungseinheit, insbesondere auf deren Ausgang bzw. Ausgangssignal keinen Einfluß mehr nehmen, außer die integrierte Überwachungseinheit vollständig abschalten, bsp. wenn der Test der integrierten Überwachungseinheit durch den Prozessor während der Initialisierungsphase negativ ausfällt. Der Start und das Abschalten der integrierten Überwachungseinheit, d.h. das Anlaufen und das Beenden der Überwachung des Prozessors durch die integrierte Überwachungseinheit, und eine Taktverschiebung des Takts von Prozessor und/oder integrierter Überwachungseinheit wird von einer mit der integrierten Überwachungseinheit verbundenen Watchdog-Einheit überwacht; diese Watchdog-Einheit ist in vielen prozessorgesteuerten Systemen (insbesondere zur Realisierung sicherheitskritischer Anwendungen) vorgesehen, um undefinierte Zustände des Systems (bsp. Endlosschleifen in der Software aufgrund eines fehlerhaften Operationscodes) zu erkennen und insbesondere durch ein Rücksetzen des Systems (einen Reset) zu beenden. Diese Watchdog-Einheit muß zur Verhinderung von auf das System einwirkenden Maßnahmen, insbesondere zur Vermeidung eines Rücksetzens (Resets) des Prozessors und damit des prozessorgesteuerten Systems, während der Programmlaufzeit des Prozessors zur permanenten Überprüfung des Prozessors zyklisch von der integrierten Überwachungseinheit rückgesetzt werden; beim Auftreten eines Fehlers wird die Watchdog-Einheit nicht zurückgesetzt, wodurch als auf das System einwirkende Maßnahmen bsp. entweder ein Reset des Prozessors und damit des Systems erzwungen wird oder das System außer Funktion gesetzt wird oder das System in einen sicheren (durch den Prozessor nicht mehr beeinflußbaren) Systemzustand gebracht wird.
Die Watchdog-Einheit als eigenständige Funktionseinheit des prozessorgesteuerten Systems kann hierbei entweder ebenfalls im integrierten Schaltkreis integriert sein - in diesem Falle kann die Watchdog-Einheit auch an das interne Bussystem des integrierten Schaltkreises angeschlossen werden oder aber außerhalb des integrierten Schaltkreises angeordnet sein - in diesem Falle kann die Verbindung zwischen dem integrierten Schaltkreis, insbesondere zwischen der integrierten Überwachungseinheit und dem Prozessor einerseits sowie der Watchdog-Einheit andererseits über eine externe Datenleitung erfolgen.
Die Kommunikation zwischen Prozessor und integrierter Überwachungseinheit zur Überwachung des Prozessors kann bsp. über ein Frage-und-Antwort-Procedere realisiert werden, in Abhängigkeit dessen Resultat die Watchdog-Einheit von der integrierten Überwachungseinheit angesteuert wird. Durch die integrierte Überwachungseinheit wird bsp. durch Vorgabe eines (bsp. in einer Tabelle abgelegten) Zahlenwerts als Anfragewert eine bestimmte Anfrage an den Prozessor gerichtet, der abhängig hiervon einen dem Anfragewert zugeordneten Algorithmus durchführt und das hieraus resultierende Ergebnis (bsp. ein binäres Ergebnis in Form einer logischen "0" oder einer logischen "1") der integrierten Überwachungseinheit mitteilt, die ihrerseits dieses Ergebnis mit einem intern (bsp. in einer Tabelle abgelegten) gespeicherten Erwartungswert vergleicht; abhängig von diesem Vergleich wird bsp. nach einer Weiterverarbeitung und/oder einer Bewertung des Ergebnisses, bsp. in Form einer Gewichtung des Ergebnisses (bsp. mittels eines Fehlerzählers) und/oder einer Wiederholung der Anfrage, die Watchdog-Einheit zurückgesetzt oder nicht zurückgesetzt, wodurch die entsprechenden Reaktionen auf den Prozessor und/oder das System initiiert werden oder unterbleiben.

Vorteilhafterweise kann mit dem vorgestellten Verfahren ein (insbesondere sicherheitskritisches) System und die korrekte Ausführung der Systemfunktion ohne das Erfordernis einer externen Überwachungseinheit und damit von zusätzlicher Hardware oder zusätzlichem Entwicklungsaufwand oder Progammieraufwand auf einfache und kostengünstige Weise überwacht werden. Weiterhin ist die Kommunikation zwischen Prozessor und integrierter Überwachungseinheit und die Synchronisation von Prozessor und integrierter Überwachungseinheit auf einfache Weise und störsicher (insbesondere gegenüber EMV-Störungen) realisierbar. Da die Watchdog-Einheit nur von der integrierten Überwachungseinheit beaufschlagt wird, kann ein einfacher Watchdog vorgesehen werden, insbesondere ein einfacher (bsp. im integrierten Schaltkreis integrierter) Fenster-Watchdog.

Im Zusammenhang mit der Zeichnung soll das Verfahren weiter erläutert werden. Hierbei zeigt
- die Figur 1: ein Ausführungsbeispiel der Komponenten eines als Mikrocontrollers ausgebildeten Prozessors, der in einem Steuergerät zur Steuerung einer sicherheitskritischen Bedienfunktion eines Kraftfahrzeugs implementiert ist,
- die Figur 2: ein Ablaufdiagramm für die Überwachungsroutine der integrierten Überwachungseinheit.

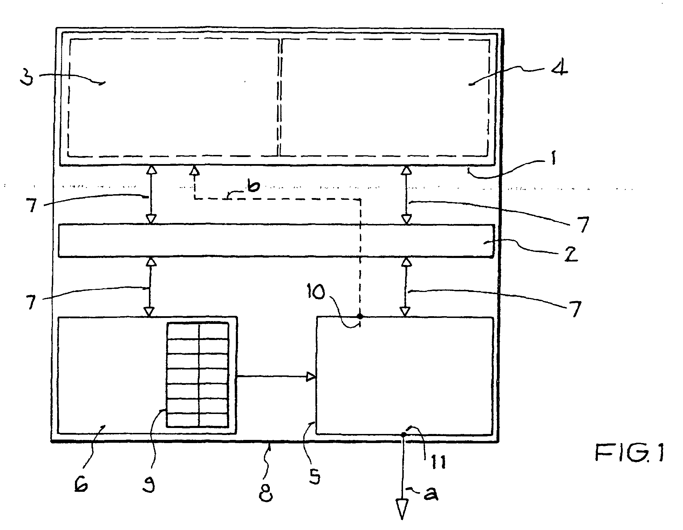

Der Mikrocontroller 1 als Einprozessorsystem ist bsp. in einem als Steuergerät zur Steuerung des Automatikgetriebes eines Kraftfahrzeugs ausgebildeten System implementiert. Der im integrierten Schaltkreis 8 integrierte Mikrocontroller 1 weist gemäß der Figur 1 als Funktionseinheiten bsp. zumindest eine zentrale Prozessoreinheit 3 (CPU) und eine Speichereinheit 4 auf; die Funktionseinheiten des Mikrocontrollers 1 sind über die Busleitungen 7 des Bussystems 2 zum Austausch von Datensignalen und Steuersignalen intern miteinander verknüpft. Im integrierten Schaltkreis 8 ist als integrierte Überwachungseinheit 6 eine integrierte Recheneinheit zur Überwachung des Mikrocontrollers 1 integriert, die ebenfalls an die Busleitungen 7 des Bussystems 2 angeschlossen ist und die bsp. eine Tabelle 9 mit Zahlenwerten als Anfragewerte, die einer bestimmten Anzahl von Algorithmen (bsp. 16 Algorithmen) entsprechen, und den Anfragewerten bzw. Algorithmen zugeordnete (bsp. binäre) Erwartungswerte beinhaltet. Weiterhin ist im integrierten Schaltkreis 8 ein Watchdog 5 vorgesehen, der von der integrierten Recheneinheit 6 angesteuert wird und der einen mit der CPU 3 des Mikrocontrollers 1 verbundenen Resetausgang 10 sowie einen bsp. Treiberstufen des Steuergeräts ansteuernden Schaltausgang 11 aufweist. Der bsp. als Fenster-Watchdog ausgebildete Watchdog 5 muß zur Überwachung der Funktionsfähigkeit des Steuergeräts zyklisch getriggert werden, bsp. alle 10 ms innerhalb eines vorgegebenen Zeitraums (innerhalb eines bestimmten Zeitfensters von bsp. 30 ms) von der integrierten Recheneinheit 6 getriggert werden.

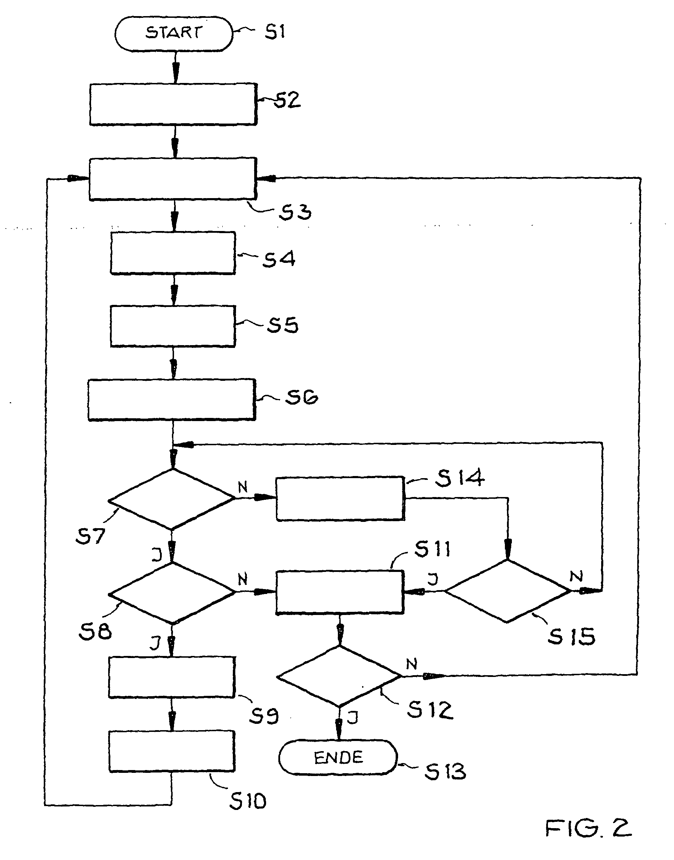

In der Figur 2 ist der Ablauf zur Überwachung des Prozessors (Mikrocontrollers) 1 durch die integrierte Überwachungseinheit (Recheneinheit) 6 unter Einbeziehen des Watchdogs 5 in einem Ablaufdiagramm dargestellt.

Nach dem Einschalten des Steuergeräts (Anlegen der Spannungsversorgung bzw. "power on") im Schritt S1 wird in der Initialisierungsphase im Schritt S2 die Funktionsfähigkeit der integrierten Recheneinheit 6 geprüft, indem alle in der Tabelle 9 der integrierten Recheneinheit 6 enthaltenen Anfragewerte und damit die den Anfragewerten zugeordneten Algorithmen des Mikrocontrollers 1 sukzessive aufgerufen werden und deren Ergebnisse mit den in der Tabelle 9 der integrierten Recheneinheit 6 enthaltenen Erwartungswerten verglichen werden.
Nach erfolgreicher Initialisierung, d.h. insbesondere bei funktionsfähiger integrierten Recheneinheit 6, wird im Schritt S3 der Antwortspeicher der CPU 3 des Mikrocontrollers 1 zurückgesetzt, im Schritt S4 der Watchdog 5 durch die integrierte Recheneinheit 6 getriggert (zurückgesetzt) und im Schritt S5 der Zeitzähler der integrierten Recheneinheit 6 zurückgesetzt.

Im Schritt S6 wird der Mikrocontroller 1 durch Vorgabe eines bestimmten Anfragewerts von der integrierten Recheneinheit 6 mit der Durchführung des diesem Anfragewert entsprechenden Algorithmus beaufschlagt.
Im Schritt S7 wird nachgefragt, ob eine Antwort seitens des Mikrocontrollers 1 erfolgt ist, d.h. ob ein Ergebnis nach Durchlaufen des vorgegebenen und bsp. in einer Speichereinheit (bsp. einem RAM) des Mikrocontrollers 1 bzw. des integrierten Schaltkreises 8 abgelegten Algorithmus (bsp. wird dieser Algorithmus unter Verwendung definierter mathematischer und/oder algebraischer Operationen durchlaufen) vom Mikrocontroller 1 (bsp. ein binärer Code als Ergebnis) innerhalb einer bestimmten Zeitspanne bzw. eines bestimmten Zeitfensters vorliegt. Ist dies der Fall, wird der Antwortspeicher der CPU 3 des Mikrocontrollers 1 gesetzt und die Antwort des Mikrocontrollers 1 von der integrierten Recheneinheit 6 im Schritt S8 bewertet, d.h. ob das vom Mikrocontroller 1 gelieferte Ergebnis (bsp. der binäre Code) dem in der Tabelle 9 der integrierten Recheneinheit 6 enthaltenen und dem durchgeführten Algorithmus zugeordneten Erwartungswert entspricht:
- Bei einer richtigen Antwort des Mikrocontrollers 1 auf die Anfrage seitens der integrierten Recheneinheit 6 wird im Schritt S9 ein in der integrierten Recheneinheit 6 angeordneter Fehlerzähler dekrementiert (bsp. um + 1 dekrementiert) und eine neue Anfrage an den Mikrocontroller 1 mit einem im Schritt S10 um + 1 inkrementierten Anfragewert gerichtet, d.h. vom Mikrocontroller 1 muß der in der Tabelle 9 der integrierten Recheneinheit 6 definierte nächstfolgende Algorithmus durchlaufen und das zugehörige Ergebnis berechnet werden usw. Hierdurch wird eine ständige (zyklische) Überprüfung der Funktionsfähigkeit des Mikrocontrollers 1 gewährleistet.
- Bei einer falschen Antwort des Mikrocontrollers 1 auf die Anfrage seitens der integrierten Recheneinheit 6 wird im Schritt S11 der Fehlerzähler der integrierten Recheneinheit 6 inkrementiert (bsp. um + 3 inkrementiert); nach Vergleich des Fehterzählers mit einem vorgegebenen Fehlerschweliwert im Schritt S 12 (bsp. beträgt dieser Fehlerschwellwert + 15) wird
   - beim Unterschreiten des Fehlerschwellwerts die Anfrage seitens der integrierten Recheneinheit 6 an den Mikrocontroller 1 mit dem gleichen Anfragewert wiederholt (Schritte S3 bis S6)
   - beim Überschreiten des Fehlerschwelfwerts insbesondere keine neue Anfrage seitens der integrierten Recheneinheit 6 an den Mikrocontroller 1 gerichtet und auch der Zeitzähler und der Watchdog 5 nicht zurückgesetzt; hierdurch werden die Ausgänge des Watchdogs 5 entsprechend umgeschaltet, insbesondere wird am Resetausgang 10 (Pfad (b) gemäß Figur 1) ein (kurzzeitiger) Reset der CPU 3 des Mikrocontrollers 1 und damit des Steuergeräts vorgenommen und durch ein entsprechendes Schaltsignal am Schaltausgang 11 (Pfad (a) gemäß Figur 1) das Steuergerät in einen sicheren Systemzustand gebracht (in diesem Systemzustand hat der Mikrocontroller 1 keinen Einfluß auf die Funktionsweise des Steuergeräts mehr), bsp. durch Abschalten von Treibern, bsp. durch Stromlosschalten von Magnetventilen (Endzustand des Systems im Schritt S13).

Falls im Schritt S7 eine Antwort des Mikrocontrollers 1 auf eine Anfrage seitens der integrierten Recheneinheit 6 innerhalb eines durch den Zeitzähler definierten Zeitfensters ausbleibt (Überprüfung des Ablaufens des Zeitzählers im Schritt S15 nach vorheriger Inkrementierung des Zeitzählers im Schritt S14, bsp. um + 1 gilt die. Antwort als falsch vom Mikrocontroller 1 beantwortet (Inkrementierung Fehlerzähfer, bsp. um + 3). Falls der Fehlerzähler kleiner als der Fehlerschwellwert ist (Abfrage im Schritt S12), muß die Anfrage seitens .der integrierten Recheneinheit 6 mit dem gleichen Anfragewert an den Mikrocontroller 1 wiederholt werden (Schritte S3 bis S6; falls der Fehlerzähler größer als der Fehlerschwellwert ist (Abfrage im Schritt S12), werden die Ausgänge 10, 11 des Watchdogs 5 entsprechend umgeschaltet (Endzustand des Systems im Schritt S13).

## Patentansprüche

1. Verfahren zum Betrieb eines von einem Prozessor (1) gesteuerten Systems, wobei zur Überwachung des Funktionszustands des Prozessors (1) eine vom Prozessor (1) unabhängige integrierte Überwachungseinheit (6) zusammen mit dem Prozessor (1) in einem integrierten Schaltkreis (8) integriert wird, und wobei eine Watchdog-Einheit (5) zur Verhinderung von auf das System einwirkenden Maßnahmen von der integrierten Überwachungseinheit (6) zyklisch zurückgesetzt werden muß, **dadurch gekennzeichnet, dass** ein Rücksetzen der Watchdog-Einheit (5) nach Maßgabe einer von der integrierten Überwachungseinheit (6) an den Prozessor (1) gerichteten Anfrage erfolgt.

2. Verfahren nach Anspruch 1, **dadurch gekennzeichnet, daß** die integrierte Überwachungseinheit (6) bei der Initialisierung des Systems vom Prozessor (1) überprüft wird.

3. Verfahren nach Anspruch 1 oder 2, **dadurch gekennzeichnet, daß** der Funktionszustand des Prozessors (1) durch die integrierte Überwachungseinheit (6) bis zu ihrem Abschalten überwacht wird.

4. Verfahren nach Anspruch 3, **dadurch gekennzeichnet, daß** die integrierte Überwachungseinheit (6) durch den Prozessor (1) abgeschaltet werden kann.

5. Verfahren nach einem der Ansprüche 1 bis 4, **dadurch gekennzeichnet, daß** die integrierte Überwachungseinheit (6) mit den Funktionseinheiten (3, 4) des Prozessors (1) über ein Bussystem (2) verbunden wird.

6. Verfahren nach einem der Ansprüche 1 bis 5, **dadurch gekennzeichnet, daß** die Watchdog-Einheit (5) von der integrierten Überwachungseinheit (6) innerhalb eines Zeitfensters zurückgesetzt werden muß.

7. Verfahren nach einem der Ansprüche 1 bis 6, **dadurch gekennzeichnet, daß** die Watchdog-Einheit (5) im integrierten Schaltkreis (8) integriert wird.

8. Verfahren nach Anspruch 1, **dadurch gekennzeichnet, daß** die Anfrage an den Prozessor (1) über einen von der integrierten Überwachungseinheit (6) vorgegebenen Anfragewert erfolgt, nach dessen Maßgabe ein bestimmter Algorithmus im Prozessor (1) durchlaufen wird, dessen Ergebnis mit einem Erwartungswert der integrierten Überwachungseinheit (6) verglichen wird.

9. Verfahren nach einem der Ansprüche 1 bis 8, **dadurch gekennzeichnet, daß** beim Ausbleiben eines Rücksetzens der Watchdog-Einheit (5) ein Rücksetzen des Prozessors (1) vorgenommen wird.

10. Verfahren nach einem der Ansprüche 1 bis 9, **dadurch gekennzeichnet, daß** beim Ausbleiben eines Rücksetzens der Watchdog-Einheit (5) das System in einen vom Prozessor (1) unabhängigen Systemzustand gebracht wird.

## Claims

1. A method for operating a system controlled by a processor (1), wherein an integrated monitoring unit (6) which is independent of the processor (1) is integrated together with the processor ,(1) in an integrated circuit (8) for the purpose of monitoring the function state of the processor (1), and wherein a watchdog unit (5) must be cyclically reset by the integrated monitoring unit (6) in order to prevent measures which affect the system, **characterised in that** the watchdog unit (5) is reset in accordance with a query which is sent by the integrated monitoring unit (6) to the processor (1).

2. A method according to claim 1, **characterised in that** the integrated monitoring unit (6) is checked by the processor (1) while the system is being initialised.

3. A method according to claim 1 or 2, **characterised in that** the function state of the processor (1) is monitored by the integrated monitoring unit (6) until it is shut down.

4. A method according to claim 3, **characterised in that** the integrated monitoring unit (6) can be shut down by the processor (1).

5. A method according to one of claims 1 to 4, **characterised in that** the integrated monitoring unit (6) is linked to the function units (3, 4) of the processor (1) via a bus system (2).

6. A method according to one of claims 1 to 5, **characterised in that** the watchdog unit (5) must be reset by the integrated monitoring unit (6) within a time window.

7. A method according to one of claims 1 to 6, **characterised in that** the watchdog unit (5) is integrated into the integrated circuit (8).

8. A method according to claim 1, **characterised in that** the query to the processor (1) is made via a query value which is specified by the integrated monitoring unit (6), and a specified algorithm which corresponds to this query value is run through in the processor (1), the outcome of which is compared with the anticipated value in the integrated monitoring unit (6).

9. A method according to one of claims 1 to 8, **characterised in that** should the watchdog unit (5) fail to be reset, the processor (1) is reset.

10. A method according to one of claims 1 to 9, **characterised in that** should the watchdog unit (5) fail to be reset, the system is brought into a system state which is independent of the processor (1).

## Revendications

1. Procédé de mise en oeuvre d'un système commandé par un processeur (1), une unité de surveillance intégrée (6) indépendante du processeur (1) étant, pour la surveillance de l'état de fonctionnement du processeur (1), intégrée dans un circuit intégré (8) en même temps que le processeur (1), et une unité de watchdog (5) devant être remise à zéro de façon cyclique par l'unité de surveillance externe (6) pour empêcher des dispositions agissant sur le système, **caractérisé en ce qu'**une remise à zéro de l'unité de watchdog (5) est effectuée au prorata d'une demande adressée au processeur (1) par l'unité de surveillance intégrée (6).

2. Procédé selon la revendication 1, **caractérisé en ce que** l'unité de surveillance intégrée (6) est contrôlée par le processeur (1) lors de l'initialisation du système.

3. Procédé selon la revendication 1 ou 2, **caractérisé en ce que** l'état de fonctionnement du processeur (1) est contrôlé par l'unité de surveillance intégrée (6) jusqu'à sa mise hors circuit.

4. Procédé selon la revendication 3, **caractérisé en ce que** l'unité de surveillance intégrée (6) peut être mise hors circuit par le processeur (1).

5. Procédé selon une des revendications 1 à 4, **caractérisé en ce que** l'unité de surveillance intégrée (6) est connectée aux unités fonctionnelles (3, 4) du processeur (1) via un système de bus (2).

6. Procédé selon une des revendications 1 à 5, **caractérisé en ce que** l'unité de watchdog (5) doit être remise à zéro par l'unité de surveillance intégrée (6) à l'intérieur d'une fenêtre de temps.

7. Procédé selon une des revendications 1 à 6, **caractérisé en ce que** l'unité de watchdog (5) est intégrée dans le circuit intégré (8).

8. Procédé selon la revendication 1, **caractérisé en ce que** la demande adressée au processeur (1) est effectuée via une valeur de demande prédéfinie par l'unité de surveillance (6), valeur au prorata de laquelle un algorithme défini est parcouru dans le processeur (1) et dont le résultat est comparé à une valeur escomptée de l'unité de surveillance intégrée (6).

9. Procédé selon une des revendications 1 à 8, **caractérisé en ce que**, en l'absence d'une remise à zéro de l'unité de watchdog (5), il est entrepris une remise à zéro du processeur (1).

10. Procédé selon une des revendications 1 à 9, **caractérisé en ce que**, lors de l'absence d'une remise à zéro de l'unité de watchdog (5), le système est amené dans un état de système indépendant du processeur (1).
